(19) Europäisches Patentamt
European Patent Office
Office européen des brevets

(11) **EP 4 564 667 A1**

(12) **EUROPEAN PATENT APPLICATION**
published in accordance with Art. 153(4) EPC

(43) Date of publication:
**04.06.2025 Bulletin 2025/23**

(21) Application number: **23859129.1**

(22) Date of filing: **11.08.2023**

(51) International Patent Classification (IPC):
**H03H 9/17** $^{(2006.01)}$

(52) Cooperative Patent Classification (CPC):
**H03H 3/02; H03H 9/02; H03H 9/17; H03H 9/54**

(86) International application number:
**PCT/CN2023/112621**

(87) International publication number:
**WO 2024/046095 (07.03.2024 Gazette 2024/10)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **27.08.2022 CN 202211036176**

(71) Applicant: **Huawei Technologies Co., Ltd.**
**Shenzhen, Guangdong 518129 (CN)**

(72) Inventors:
• **TAO, Xiang**
**Shenzhen, Guangdong 518129 (CN)**

• **JIANG, Xin**
**Shenzhen, Guangdong 518129 (CN)**
• **TANG, Daiping**
**Shenzhen, Guangdong 518129 (CN)**
• **GU, Jian**
**Shenzhen, Guangdong 518129 (CN)**
• **KE, Han**
**Shenzhen, Guangdong 518129 (CN)**
• **LUAN, Zhongzhi**
**Shenzhen, Guangdong 518129 (CN)**

(74) Representative: **Körber, Martin Hans**
**Mitscherlich PartmbB**
**Patent- und Rechtsanwälte**
**Karlstraße 7**
**80333 München (DE)**

(54) **LAMB WAVE RESONATOR AND PREPARATION METHOD THEREFOR, FILTER, RADIO FREQUENCY MODULE, AND ELECTRONIC DEVICE**

(57)    Embodiments of this application provide a lamb (lamb) wave resonator and a preparation method, a filter, a radio frequency module, and an electronic device. The lamb wave resonator includes: a substrate, an acoustic wave reflection layer disposed on the substrate, a piezoelectric layer disposed on the acoustic wave reflection layer, and an interdigital transducer disposed on the piezoelectric layer. An acoustic impedance of the acoustic wave reflection layer is less than an acoustic impedance of the piezoelectric layer, and an acoustic wave reflection coefficient of a surface that is of the acoustic wave reflection layer and that faces the piezoelectric layer is R, where $0.5 \leq R \leq 0.86$.

FIG. 5

EP 4 564 667 A1

**Description**

This application claims priority to Chinese Patent Application No. 202211036176.3, filed with the China National Intellectual Property Administration on August 27, 2022 and entitled "LAMB WAVE RESONATOR AND PREPARATION METHOD, FILTER, RADIO FREQUENCY MODULE, AND ELECTRONIC DEVICE", which is incorporated herein by reference in its entirety.

**TECHNICAL FIELD**

This application relates to the field of radio frequency technologies, and in particular, to a lamb wave resonator and a preparation method, a filter, a radio frequency module, and an electronic device.

**BACKGROUND**

Explosive growth of mobile data drives the communication industry to move toward a fifth generation mobile communication technology (5th generation mobile communication technology, 5G). This requires radio frequency front-end resonators to have a higher frequency, a larger bandwidth, and stronger power tolerance. At present, the radio frequency front-end resonators are mainly classified into surface acoustic wave (surface acoustic wave, SAW) resonators and bulk acoustic wave (bulk acoustic wave, BAW) resonators. The SAW resonators have a frequency lower than 3.5 GHz and an electromechanical coupling coefficient of only about 10%. The BAW resonators also have a small electromechanical coupling coefficient. Lamb wave (lamb wave) resonators have become a research hotspot in recent years because of their advantages such as a high acoustic velocity (for example, 12000 m/s to 15000 m/s) and a large electromechanical coupling coefficient (for example, up to 25%).

However, a current process of preparing the lamb wave resonators is complex and has low yield. Therefore, how to prepare lamb wave resonators with high yield by using a simple process becomes a technical problem to be urgently resolved.

**SUMMARY**

Embodiments of this application provide a lamb wave resonator and a preparation method, a filter, a radio frequency module, and an electronic device, to resolve problems of a complex process and low yield in current preparation of the lamb wave resonator.

To achieve the foregoing objective, this application uses the following technical solutions.

According to a first aspect of embodiments of this application, a lamb (lamb) wave resonator is provided. The lamb wave resonator is used as an element of a filter, and may be used in a radio frequency device. The lamb wave resonator includes: a substrate, an acoustic wave reflection layer disposed on the substrate, a piezoelectric layer disposed on the acoustic wave reflection layer, and an interdigital transducer disposed on the piezoelectric layer. An acoustic impedance of the acoustic wave reflection layer is smaller than an acoustic impedance of the piezoelectric layer. After a material of the piezoelectric layer is selected, an acoustic wave reflection coefficient of a surface that is of the acoustic wave reflection layer and that faces the piezoelectric layer may be limited to 0.5 to 0.86 ($0.5 \leq$ the acoustic wave reflection coefficient $R \leq 0.86$) by adjusting a material and a thickness of the acoustic wave reflection layer. In this way, sound waves in modes such as A1, S0, and SH0 are reflected at an interface that is of the acoustic wave reflection layer and that faces the piezoelectric layer, to lock the sound waves in the piezoelectric layer.

According to the lamb wave resonator provided in this embodiment of this application, the acoustic wave reflection layer is disposed on a side that is of the piezoelectric layer and that is close to the substrate, and the acoustic impedance of the acoustic wave reflection layer is less than the acoustic impedance of the piezoelectric layer. In this way, an acoustic wave excited by the lamb wave resonator is reflected on the surface that is of the acoustic wave reflection layer and that faces the piezoelectric layer, and is reflected back to the piezoelectric layer. The acoustic wave can be locked in the piezoelectric layer by using a single acoustic wave reflection layer formed on the substrate, thereby avoiding a problem of serious degradation of device performance caused by a large quantity of sound waves excited by the lamb wave resonator leaking to the substrate. The acoustic wave reflection layer replaces a conventional air cavity and a Bragg reflector structure, eliminating the need to hollow out the cavity or form the complex Bragg reflector structure, thereby simplifying a preparation process of the lamb wave resonator and reducing a preparation difficulty of the lamb wave resonator. In addition, in the lamb wave resonator provided in this application, no air cavity may need to be formed in the substrate. When no air cavity is disposed in the substrate, mechanical strength of the lamb wave resonator can be enhanced, and yield of the lamb wave resonator can be improved.

On this basis, the acoustic wave reflection coefficient R of the surface that is of the acoustic wave reflection layer and that faces the piezoelectric layer is limited to 0.5 to 0.86, so that an acoustic wave mode can be better limited in the piezoelectric layer. In addition, this can resolve a problem that the acoustic wave cannot be well limited in the piezoelectric layer because of an excessively small acoustic wave reflection coefficient R (less than 0.5), or that the acoustic wave reflection layer used to limit the acoustic wave needs to be very thick and thus is difficult to implement in engineering. This can also resolve problems that product yield is affected due to the facts that parameters such as a density and a Young's modulus of a material of the acoustic wave reflection layer are small and the material is soft because of an excessively large acoustic wave reflection coefficient R (greater than 0.86), and that the piezoelectric layer above the acoustic wave reflection layer is wrinkled or broken because the acoustic wave reflection layer is prone to deform in a processing process of the lamb wave resonator (for example, annealing after the piezoelectric layer is bonded).

In a possible implementation, $0.55 \leq R \leq 0.8$. The acoustic wave reflection coefficient R is limited to 0.55 to 0.8, so that issues such as material selection, thickness setting, and preparation process of the acoustic wave reflection layer can be considered while satisfying device performance, thereby reducing preparation costs.

In a possible implementation, a minimum thickness of the acoustic wave reflection layer is y, where $y = 77.75379 * R^2 - 173.22328 * R + 97.70404$. In this embodiment of this application, a material selection range of the acoustic wave reflection layer is wide, an acoustic wave reflection coefficient R of the acoustic wave reflection layer of each material is different, and a thickness of the acoustic wave reflection layer of each material is also different. In this application, the minimum thickness of the acoustic wave reflection layer is limited, so that a feature of the lamb wave resonator can satisfy a requirement, and preparation of the acoustic wave reflection layer can be facilitated, so as to consider a plurality of features such as performance, costs, processes, and reliability of the lamb wave resonator.

In a possible implementation, a thickness of the acoustic wave reflection layer is 3.5 μm to 30 μm. This is a thickness range that facilitates mass production.

In a possible implementation, a material of the acoustic wave reflection layer is a macromolecular material. In this embodiment of this application, a material selection range of the acoustic wave reflection layer is wide, which facilitates implementation.

In a possible implementation, the material of the acoustic wave reflection layer includes polyimide, polydimethylsiloxane, polymethyl methacrylate, polyvinylidene fluoride, or polyethylene glycol terephthalate. These are some low-cost, easy-to-implement materials for selection.

In a possible implementation, the acoustic wave reflection layer is of a single membrane layer structure. The acoustic wave reflection layer of the single membrane layer structure is simple in structure and process.

In a possible implementation, a cutting direction of a material of the piezoelectric layer is Z-cut. The piezoelectric layer of this material may allow the lamb wave resonator to have a wide bandwidth.

In a possible implementation, a Euler angle of the material of the piezoelectric layer is (0, 20, 0) to (0, 40, 0). The Euler angle within this range may allow the lamb wave resonator to have a wide bandwidth.

In a possible implementation, the lamb wave resonator further includes a frequency shift layer, where the frequency shift layer is configured to adjust a frequency of the lamb wave resonator; and the frequency shift layer is disposed between the piezoelectric layer and the acoustic wave reflection layer. When the lamb wave resonator includes the frequency shift layer, a structure of another membrane layer in the lamb wave resonator does not need to be changed, and the frequency of the lamb wave resonator may be adjusted to a required value by adjusting a thickness of the frequency shift layer.

In a possible implementation, the lamb wave resonator further includes a frequency shift layer, where the frequency shift layer is configured to adjust a frequency of the lamb wave resonator; and the frequency shift layer is disposed on a side that is of the interdigital transducer and that is away from the piezoelectric layer. When the lamb wave resonator includes the frequency shift layer, a structure of another membrane layer in the lamb wave resonator does not need to be changed, and the frequency of the lamb wave resonator may be adjusted to a required value by adjusting a thickness of the frequency shift layer.

In a possible implementation, the lamb wave resonator further includes a temperature compensation layer, where the temperature compensation layer is configured to compensate for a temperature coefficient of frequency of the lamb wave resonator; and the temperature compensation layer is disposed between the piezoelectric layer and the acoustic wave reflection layer. When the lamb wave resonator includes the temperature compensation layer, temperature compensation may be performed on the lamb wave resonator by using the temperature compensation layer, so that an absolute value of the temperature coefficient of frequency (temperature coefficient of frequency, TCF) of the lamb wave resonator decreases.

In a possible implementation, the lamb wave resonator further includes a temperature compensation layer, where the temperature compensation layer is configured to compensate for a temperature coefficient of frequency of the lamb wave resonator; and the temperature compensation layer is disposed on the side that is of the interdigital transducer and that is away from the piezoelectric layer. When the lamb wave resonator includes the temperature compensation layer, temperature compensation may be performed on the lamb wave resonator by using the temperature compensation layer, so that an absolute value of the temperature coefficient of frequency (temperature coefficient of frequency, TCF) of the lamb wave resonator decreases.

In a possible implementation, a thickness of the piezoelectric layer is 0.2 $\mu$m to 1 $\mu$m. The thickness of the piezoelectric layer 130 is limited to less than 1 $\mu$m, so that requirements for the bandwidth and the frequency of the lamb wave resonator 100 can be satisfied, and the lamb wave resonator 100 can be miniaturized. In a possible implementation, the interdigital transducer includes a plurality of first electrode fingers and a plurality of second electrode fingers, where the plurality of first electrode fingers and the plurality of second electrode fingers are sequentially alternately arranged, and a width of each of the first electrode finger and the second electrode finger is 200 nm to 1000 nm. In this way, the lamb wave resonator can operate in a 5G frequency band, and has a wide bandwidth.

In a possible implementation, the interdigital transducer includes a plurality of first electrode fingers and a plurality of second electrode fingers, where the plurality of first electrode fingers and the plurality of second electrode fingers are sequentially alternately arranged, and a pitch between the first electrode finger and the second electrode finger that are adjacent is 2 $\mu$m to 10 $\mu$m. In this way, the lamb wave resonator can operate in a 5G frequency band, and has a wide bandwidth.

In a possible implementation, a phononic crystal layer is further disposed between the substrate and the acoustic wave reflection layer. The phononic crystal layer is disposed in the lamb wave resonator, so that the phononic crystal layer may further limit an acoustic wave, supplement an acoustic wave reflection function to the acoustic wave reflection layer, and improve the bandwidth of the lamb wave resonator.

In a possible implementation, a surface that is of the substrate and that faces the acoustic wave reflection layer is a plane. The substrate does not need to be hollowed out, allowing for a simple preparation process with high reliability.

In a possible implementation, no opening is disposed in the substrate. The substrate does not need to be hollowed out, allowing for a simple preparation process with high reliability.

A second aspect of embodiments of this application provides a filter, including a plurality of cascaded lamb wave resonators, where the lamb wave resonator is the lamb wave resonator according to any one of the first aspect.

The filter provided in the second aspect of embodiments of this application includes the lamb wave resonator in the first aspect, and beneficial effect of the lamb wave resonator is the same as beneficial effect of the lamb wave resonator. Details are not described herein again.

According to a third aspect of embodiments of this application, a radio frequency module is provided, including a filter and a power amplifier, where the filter is coupled to the power amplifier, and the filter is the filter in the second aspect.

The radio frequency module provided in the third aspect of embodiments of this application includes the lamb wave resonator in the first aspect, and beneficial effect of the lamb wave resonator is the same as beneficial effect of the lamb wave resonator. Details are not described herein again.

A fourth aspect of embodiments of this application provides an electronic device, including a filter and a circuit board, where the filter is disposed on the circuit board, and the filter is the filter in the second aspect.

The electronic device provided in the fourth aspect of embodiments of this application includes the lamb wave resonator in the first aspect, and beneficial effect of the lamb wave resonator is the same as beneficial effect of the lamb wave resonator. Details are not described herein again.

A fifth aspect of embodiments of this application provides a preparation method for a lamb wave resonator, where the method is used to prepare the lamb wave resonator according to any one of the first aspect.

**BRIEF DESCRIPTION OF DRAWINGS**

FIG. 1 is a diagram of a framework of an electronic device according to an embodiment of this application;
FIG. 2 is a diagram of a topology structure of a filter according to an embodiment of this application;
FIG. 3 is a diagram of particle displacement of a lamb wave resonator according to an embodiment of this application;
FIG. 4A is a diagram of a structure of a back-etched lamb wave resonator according to an embodiment of this application;
FIG. 4B is a diagram of a structure of an air-gap lamb wave resonator according to an embodiment of this application;
FIG. 4C is a diagram of a structure of a solidly mounted lamb wave resonator according to an embodiment of this application;
FIG. 5 is a diagram of a structure of a lamb wave resonator according to an embodiment of this application;
FIG. 6A is a modeling diagram of a lamb wave resonator according to an embodiment of this application;
FIG. 6B to FIG. 6D are diagrams of particle displacement distribution of a lamb wave resonator in a vertical direction when a thickness of an acoustic wave reflection layer is different;
FIG. 6E is a diagram of an admittance curve of a lamb wave resonator 100 according to an embodiment of this application;
FIG. 7 is a diagram of a structure of an interdigital transducer according to an embodiment of this application;
FIG. 8 is a diagram of a structure of another lamb wave resonator according to an embodiment of this application;

FIG. 9 is a diagram of a structure of still another lamb wave resonator according to an embodiment of this application; and

FIG. 10 is a diagram of a structure of yet another lamb wave resonator according to an embodiment of this application.

Reference numerals:

1: electronic device; 11: cover; 12: display; 13: middle frame; 131: bearing plate; 132: bezel; 14: rear housing; 10: filter; 100: resonator; 110: substrate; 120: acoustic wave reflection layer; 130: piezoelectric layer; 140: interdigital transducer; 141a: first busbar; 142a: second busbar; 141b: first electrode finger; 142b: second electrode finger; 150: frequency shift layer; 160: phononic crystal layer.

## DESCRIPTION OF EMBODIMENTS

The following describes the technical solutions in embodiments of this application with reference to the accompanying drawings in embodiments of this application. It is clear that the described embodiments are merely a part rather than all of embodiments of this application.

Terms such as "first" and "second" below are merely for ease of description, and shall not be understood as an indication or implication of relative importance or implicit indication of a quantity of indicated technical features. Therefore, a feature limited by "first", "second", or the like may explicitly or implicitly include one or more features. In the descriptions of this application, unless otherwise stated, "a plurality of" means two or more than two.

In addition, in embodiments of this application, orientation terms such as "upper", "lower", "left", and "right" may include but are not limited to definitions based on illustrated orientations in which components in the accompanying drawings are placed. It should be understood that, these directional terms may be relative concepts. They are used for description and clarification of relative positions, and may vary accordingly depending on a change in the orientations in which the components in the accompanying drawings are placed in the accompanying drawings.

In embodiments of this application, unless otherwise clearly specified and limited, a term "connection" should be understood in a broad sense. For example, the "connection" may be a fixed connection, a detachable connection, or an integrated connection, or may be a direct connection or an indirect connection implemented through an intermediate medium. In addition, a term "coupling" may be a direct electrical connection, or may be an indirect electrical connection through an intermediate medium. A term "contact" may be direct contact or indirect contact through an intermediate medium.

In embodiments of this application, a term "and/or" describes an association relationship between associated objects and indicates that three relationships may exist. For example, A and/or B may indicate the following cases: Only A exists, both A and B exist, and only B exists, where A and B may be singular or plural. The character "/" generally indicates an "or" relationship between the associated objects.

An embodiment of this application provides an electronic device. The electronic device is, for example, a consumer electronic product, a home electronic product, a vehicle-mounted electronic product, a financial terminal product, or a communication electronic product. The consumer electronic product is, for example, a mobile phone (mobile phone), a tablet computer (pad), a notebook computer, an e-reader, a personal computer (personal computer, PC), a personal digital assistant (personal digital assistant, PDA), a desktop display, a smart wearable product (for example, a smartwatch or a smart band), a virtual reality (virtual reality, VR) terminal device, an augmented reality (augmented reality, AR) terminal device, or an unmanned aerial vehicle. The home electronic product is, for example, an intelligent lock, a television, a remote control, a refrigerator, and a small household charging appliance (such as a soy milk maker and a robot vacuum). The vehicle-mounted electronic product is, for example, a vehicle-mounted navigator, or a vehicle-mounted high-density digital video disc (digital video disc, DVD). The financial terminal product is, for example, an automated teller machine (automated teller machine, ATM), or a terminal for self-service business handling. For example, the communication electronic product is a communication device like a server, a memory, a radar, or a base station.

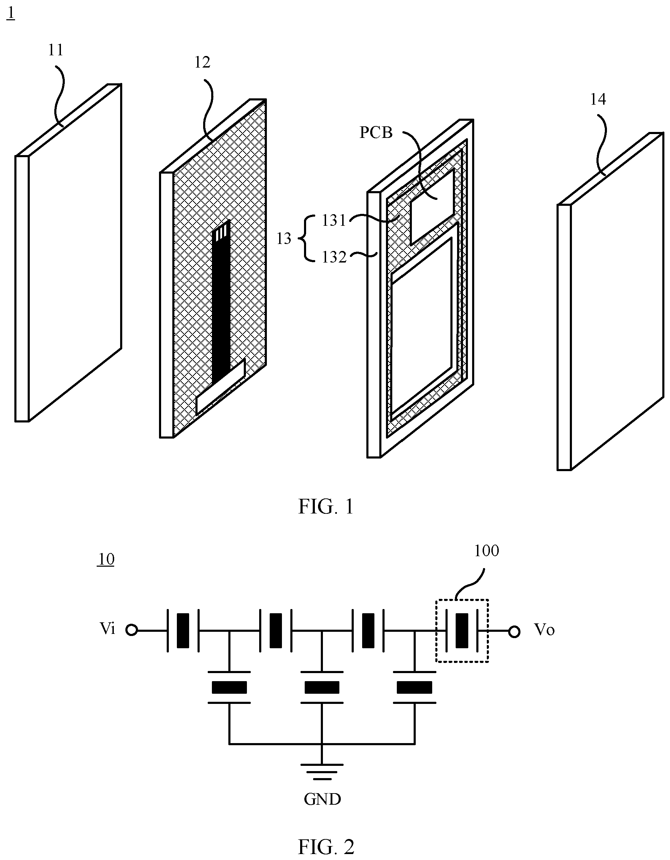

For ease of description, the following uses an example in which the electronic device is a mobile phone for description. As shown in FIG. 1, an electronic device 1 mainly includes a cover 11, a display 12, a middle frame 13, and a rear housing 14. The rear housing 14 and the display 12 are respectively located on two sides of the middle frame 13, the middle frame 13 and the display 12 are disposed in the rear housing 14, the cover 11 is disposed on a side that is of the display 12 and that is away from the middle frame 13, and a display surface of the display 12 faces the cover 11.

The display 12 may be a liquid crystal display (liquid crystal display, LCD). In this case, the liquid crystal display includes a liquid crystal display panel and a backlight module. The liquid crystal display panel is disposed between the cover 11 and the backlight module, and the backlight module is configured to provide a light source for the liquid crystal display panel. The display 12 may alternatively be an organic light emitting diode (organic light emitting diode, OLED) display. Because the OLED display is a self-luminous display, no backlight module needs to be disposed.

The middle frame 13 includes a bearing plate 131 and a bezel 132 around the bearing plate 131. The electronic device 1 may further include electronic components such as a printed circuit board (printed circuit board, PCB), a battery, and a camera. The electronic components such as the printed circuit board, the battery, and the camera may be disposed on the bearing plate 131.

The electronic device 1 may further include a system on chip (system on chip, SOC), a radio frequency chip, and the like that are disposed on the PCB. The PCB is configured to carry the system on chip, the radio frequency chip, and the like, and is electrically connected to the system on chip, the radio frequency chip, and the like. The radio frequency chip may include parts such as a filter and a processor. The processor is configured to process various signals. The filter is an important part of radio frequency signal processing, and is configured to block a signal of another frequency through a signal of a specific frequency.

An embodiment of this application provides a filter. The filter may be used in the electronic device 1, for example, used in a radio frequency chip in the electronic device 1. The filter provided in this embodiment of this application may be, for example, a low-pass filter, a high-pass filter, a band-pass filter, a band-stop filter, an active filter, or the like.

Certainly, the filter provided in this embodiment of this application is not limited to being integrated into the electronic device 1. Alternatively, the filter may be independently used as a component, or the filter may be integrated with components such as a power amplifier into a module (for example, a radio frequency component, a radio frequency module, a filter module, or the like). The filter is coupled to the power amplifier to perform signal processing and transmission.

As shown in FIG. 2, the filter 10 provided in this embodiment of this application includes a plurality of cascaded lamb wave (lamb wave) resonators 100. The plurality of lamb (lamb) wave resonators 100 may have different resonance frequencies, and may be cascaded together in a series-parallel manner. FIG. 2 further shows a signal input end Vi, a signal output end Vo, and a ground end GND that are of the filter 10.

Herein, the lamb wave resonator 100 has advantages such as a high acoustic velocity (for example, 12000 m/s to 15000 m/s) and a large electromechanical coupling coefficient (for example, up to 25%), and is mainly used in various radio frequency terminal devices. The filter 10 formed by cascading the series-parallel lamb wave resonators 100 having different resonance frequencies has advantages such as a small passband insertion loss, a high out-of-band steepness, and strong power tolerance.

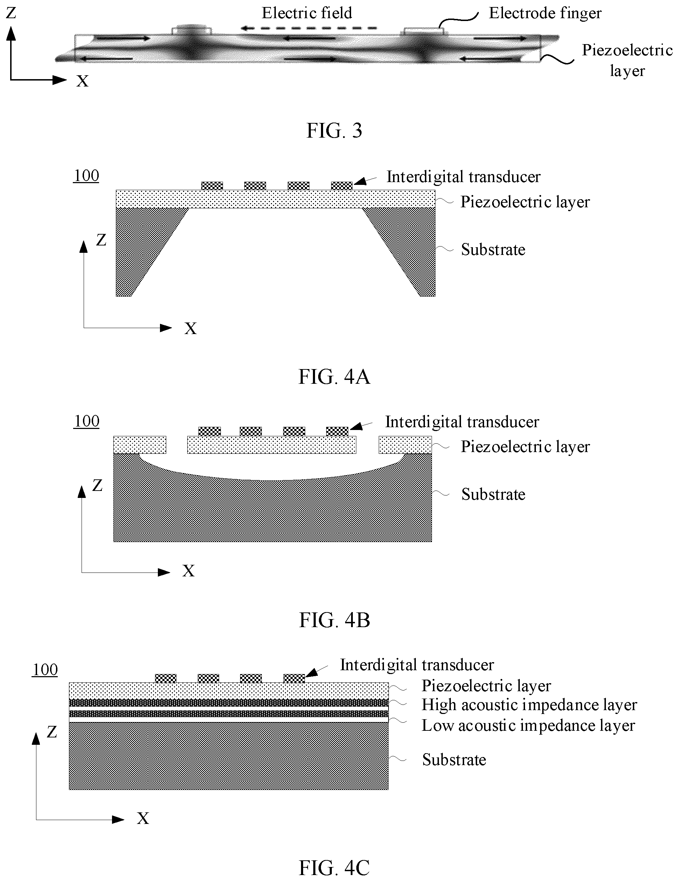

A diagram of particle displacement of the lamb wave resonator 100 is shown in FIG. 3 (FIG. 3 shows only a piezoelectric layer and a single pair of electrode fingers). When an alternating field is applied to an electrode finger, an electric field direction is mainly horizontal (a direction X in FIG. 3), or parallel to the piezoelectric layer, and a shear wave propagated along a thickness direction of the piezoelectric layer is excited, and the thickness direction is a direction Z in FIG. 3. In FIG. 3, a solid line arrow represents a vibration direction of a particle, and a dashed line arrow represents the electric field direction.

To allow the lamb wave resonator 100 to have a high acoustic velocity and a large electromechanical coupling coefficient, it is usually necessary to limit acoustic wave energy to the piezoelectric layer.

To achieve the foregoing objective, in some technologies, as shown in FIG. 4A, the lamb wave resonator 100 is of a back-etched structure. A back etching process is used to remove a substrate below a middle area of the piezoelectric layer, so that the piezoelectric layer in the middle area is suspended and a lower surface of the piezoelectric layer is in contact with air. An acoustic impedance of air is low, which allows an acoustic wave to be reflected back to the piezoelectric layer, thereby limiting the acoustic wave energy to the piezoelectric layer.

The lamb wave resonator 100 of the back-etched structure has a simple process, but silicon below the piezoelectric layer is removed, resulting in poor mechanical strength and low yield of the lamb wave resonator 100.

In some other technologies, as shown in FIG. 4B, the lamb wave resonator 100 is of an air-gap structure. A release window is etched in the piezoelectric layer by using an etching process, and then the substrate or a sacrificial layer below the middle area of the piezoelectric layer is released by using a release process, so that the piezoelectric layer in the middle area is suspended and a lower surface of the piezoelectric layer is in contact with air. An acoustic impedance of air is low, which allows an acoustic wave to be reflected back to the piezoelectric layer, thereby limiting the acoustic wave to the piezoelectric layer.

Mechanical strength of the lamb wave resonator 100 of the air-gap structure is higher than that of the lamb wave resonator 100 with the back-etched structure. However, a cavity needs to be hollowed out during manufacturing of the lamb wave resonator 100 with the air-gap structure, resulting in a complex process.

In some other technologies, as shown in FIG. 4C, the lamb wave resonator 100 is of a solidly mounted structure. A Bragg reflector (Bragg reflector) structure consisting of alternating high acoustic impedance layer and low acoustic impedance layer is fabricated below the piezoelectric layer to limit the acoustic wave to the piezoelectric layer. A material of the low acoustic impedance layer may be, for example, zinc oxide, silicon dioxide, and the like, and a material of the high acoustic impedance layer may be, for example, a heavy metal and the like. The heavy metal means a metal with a density greater than 4.5 g/cm$^3$, including gold, silver, copper, iron, mercury, lead, cadmium, and the like. The acoustic wave is reflected at a junction of the low acoustic impedance layer and the high acoustic impedance layer, and is reflected back to the piezoelectric layer. The low acoustic impedance layer is a membrane layer whose acoustic impedance is slightly lower than that of the high acoustic impedance layer, and the acoustic impedance of both the low acoustic impedance layer and the high acoustic impedance layer may be greater than that of the piezoelectric layer.

For the lamb wave resonator 100 of the solidly mounted structure, a thickness of each layer in a Bragg reflector layer needs to be accurately controlled. Consequently, a process is complex, yield is difficult to improve, and costs are high, which affects mass production of devices.

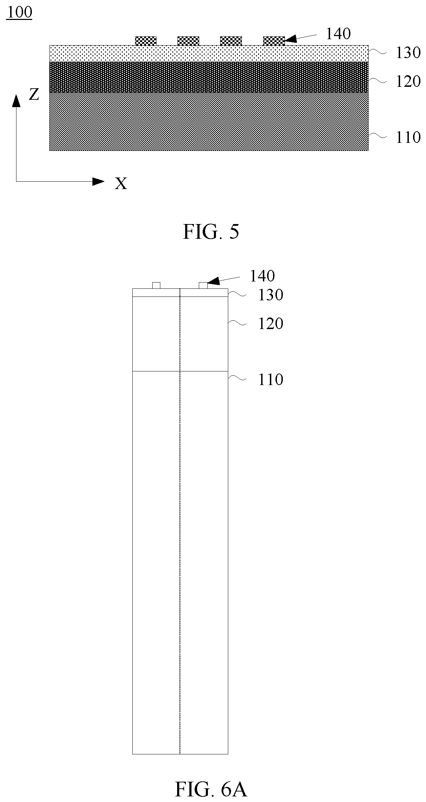

An embodiment of this application provides a lamb wave resonator. As shown in FIG. 5, a lamb wave resonator 100 includes a substrate 110, an acoustic wave reflection layer 120, a piezoelectric layer 130, and an interdigital transducer 140.

A material of the substrate 110 may be, for example, lithium niobate ($LiNbO_3$, LN), lithium tantalate ($LiTaO_3$, LT), quartz (quartz), silicon (Si), ceramics (ceramics), glass (glass), or the like. Main components of the ceramics include, for example, silicates, aluminosilicates, refractory metal oxides, metal nitrides, and borides, and main components of the glass include, for example, hexa-silicon dioxide combined with calcium oxide and sodium oxide ($Na_2O.CaO.6SiO_2$).

In some embodiments, a structure of the substrate 110 is any substrate structure in a conventional technology. For example, the structure of the substrate 110 is any structure shown in FIG. 4A to FIG. 4C.

In some other embodiments, a surface that is of the substrate 110 and that faces the acoustic wave reflection layer 120 is a plane. For example, no part of the surface that is of the substrate 110 and that faces the acoustic wave reflection layer 120 is removed, no opening is disposed in the substrate 110, and no air cavity exists between the substrate 110 and a membrane layer (for example, the acoustic wave reflection layer 120) disposed on a surface of the substrate 110.

The acoustic wave reflection layer 120 is disposed on a side of the substrate 110. For example, the acoustic wave reflection layer 120 may be disposed on the surface of the substrate 110.

The piezoelectric layer 130 is disposed on a side that is of the acoustic wave reflection layer 120 and that is away from the substrate 110. For example, the piezoelectric layer 130 may be disposed on a surface of the acoustic wave reflection layer 120.

When materials are selected for the acoustic wave reflection layer 120 and the piezoelectric layer 130, an acoustic impedance of the piezoelectric layer 130 is greater than an acoustic impedance of the acoustic wave reflection layer 120, so that an acoustic wave is reflected on a surface that is of the acoustic wave reflection layer 120 and that faces the piezoelectric layer 130, and is reflected back to the piezoelectric layer 130.

It should be emphasized that, in this application, no limitation is imposed on a size relationship between the acoustic impedance of the acoustic wave reflection layer 120 and an acoustic impedance of the substrate 110, provided that the acoustic impedance of the acoustic wave reflection layer 120 is less than the acoustic impedance of the piezoelectric layer 130. The acoustic impedance of the acoustic wave reflection layer 120 may be less than the acoustic impedance of the substrate 110, the acoustic impedance of the acoustic wave reflection layer 120 may alternatively be greater than the acoustic impedance of the substrate 110, and the acoustic impedance of the acoustic wave reflection layer 120 may alternatively be equal to the acoustic impedance of the substrate 110.

Acoustic impedance (acoustic impedance) is a term in mechanics, and means a complex ratio of a pressure of a medium on an area of a wavefront to a volume velocity of the medium passing through the area. A unit of the acoustic impedance is Pascal per square meter per second ($Pa\ m^{-2}s^{-1}$).

The acoustic impedance $Z_{120}$ of the acoustic wave reflection layer and the acoustic impedance $Z_{130}$ of the piezoelectric layer may be respectively obtained through calculation by using the following formulas:

$$Z_{120} = v_{120} * \rho_{120};$$

and

$$Z_{130} = v_{130} * \rho_{130}$$

In an example in which the lamb wave is in a first-order anti-symmetric (A1) mode, and the acoustic wave reflection layer 120 is made of an isotropic material:

$$Z_{120} = v_{120} * \rho_{120} = \sqrt{\frac{E}{2 * \rho_{120} * (1+\sigma)}} * \rho_{120} = \sqrt{\frac{E * \rho_{120}}{2 * (1+\sigma)}};$$

and

$$Z_{130} = v_{130} * \rho_{130} = \sqrt{\frac{C_{44}}{\rho_{130}}} * \rho_{130} = \sqrt{C_{44} * \rho_{130}}$$

$v_{120}$ and $v_{130}$ are shear wave velocities in a direction Z of the acoustic wave reflection layer 120 and the piezoelectric layer 130, $\rho_{120}$ and $\rho_{130}$ are densities of the acoustic wave reflection layer 120 and the piezoelectric layer 130, $C_{44}$ is an elastic stiffness coefficient of the piezoelectric layer 130, E is a Young's modulus (Young's modulus) of the acoustic wave reflection layer 120, where a unit of the Young's modulus is Pa, Mpa, or Gpa, and $\sigma$ is a Poisson's ratio (Poisson's ratio) of the acoustic wave reflection layer 120.

In some embodiments, a larger acoustic wave reflection coefficient R of the surface that is of the acoustic wave reflection layer 120 and that faces the piezoelectric layer 130 indicates better limiting effect on an acoustic wave.

The acoustic wave reflection coefficient R may be obtained through calculation by using the following formula:

$$R = \left| \frac{Z_{130} - Z_{120}}{Z_{130} + Z_{120}} \right|$$

The acoustic wave reflection coefficient R is related to the limiting effect of the acoustic wave.

In some embodiments, a value range of the acoustic wave reflection coefficient R is 0.5≤R<0.86. For example, a value of the acoustic wave reflection coefficient R is 0.6, 0.65, 0.7, 0.75, 0.8, or 0.85.

The acoustic wave reflection coefficient R is limited to be greater than or equal to 0.5, so that the acoustic wave may be effectively limited in the piezoelectric layer 130, and performance of the lamb wave resonator 100 provided in this embodiment of this application may be similar to performance of an air-gap lamb wave resonator.

In addition, this can resolve a problem that the acoustic wave cannot be well limited in the piezoelectric layer 130 because of an excessively small acoustic wave reflection coefficient R (less than 0.5), or that the acoustic wave reflection layer 120 used to limit the acoustic wave needs to be very thick and thus is difficult to implement in engineering. This can also resolve problems that product yield is affected due to the facts that parameters such as a density and a Young's modulus of a material of the acoustic wave reflection layer 120 are small and the material is soft because of an excessively large acoustic wave reflection coefficient R (greater than 0.86), and that the piezoelectric layer 130 above the acoustic wave reflection layer 120 is wrinkled or broken because the acoustic wave reflection layer 120 is prone to deform in a processing process of the lamb wave resonator 100 (for example, annealing after the piezoelectric layer is bonded).

The material of the acoustic wave reflection layer 120 may be any material satisfying the acoustic wave reflection coefficient R.

In some embodiments, the material of the acoustic wave reflection layer 120 is a macromolecular material (macromolecular material).

The macromolecular material, also referred to as a polymer material, is a material formed by using a macromolecular compound as a matrix, combined with other additives (assistants).

For example, the material of the acoustic wave reflection layer 120 includes polyimide (polyimide, PI), polydimethylsiloxane (polydimethylsiloxane, PDMS), polymethyl methacrylate (polymethyl methacrylate, PMMA), polyvinylidene fluoride (polyvinylidene fluoride, PVDF), or polyethylene glycol terephthalate (polyethylene glycol terephthalate, PET).

For example, the acoustic wave reflection layer 120 may be formed by using a process such as spin coating, magnetron sputtering, physical vapor deposition, chemical vapor deposition, epitaxial growth, or the like. This allows for a simple process, low costs, and high yield.

Based on the foregoing formula, as shown in Table 1, acoustic wave reflection coefficients R of several optional materials in this embodiment of this application may be obtained.

Table 1 Acoustic velocities, acoustic impedances, and acoustic wave reflection coefficients of different materials

| Material | Vertical shear wave velocity (m/s) | Acoustic impedance Z (MRayl) | Acoustic wave reflection coefficient R |
|---|---|---|---|
| Z-cut LiNbO$_3$ | 3570 | 16.7793 | |
| PI | 943.28 | 1.2263 | 0.863786822 |
| PDMS | 16.107 | 0.0156 | 0.998142293 |
| PMMA | 948.87 | 1.1292 | 0.873892286 |
| PVDF | 838.56 | 1.4238 | 0.843565107 |

(continued)

| Material | Vertical shear wave velocity (m/s) | Acoustic impedance Z (MRayl) | Acoustic wave reflection coefficient R |
|---|---|---|---|
| PET | 1055.41 | 1.4248 | 0.843463835 |

In some embodiments, as shown in FIG. 5, the acoustic wave reflection layer 120 is a single membrane layer.

It may also be understood that the acoustic wave reflection layer 120 is a single membrane layer, and is not a structure formed by stacking a plurality of membrane layers.

In this embodiment of this application, based on an acoustic impedance difference between the acoustic wave reflection layer 120 and the piezoelectric layer 130, the acoustic wave is reflected on the surface that is of the acoustic wave reflection layer 120 and that faces the piezoelectric layer 130. Therefore, the acoustic wave reflection layer 120 is a single membrane layer, and has a simple structure and a simple preparation process.

Certainly, the acoustic wave reflection layer 120 may alternatively include a plurality of membrane layers, and is a structure formed by stacking the plurality of membrane layers.

A specific structure of the acoustic wave reflection layer 120 is not limited in embodiments of this application, and a relationship between acoustic impedances of the plurality of membrane layers is not limited either, provided that the acoustic wave can be reflected on the surface that is of the acoustic wave reflection layer 120 and that faces the piezoelectric layer 130.

In some embodiments, a material of the piezoelectric layer 130 includes one or more of piezoelectric materials such as $LiNbO_3$, $LiTaO_3$, aluminum nitride (AlN), zinc oxide (ZnO), or quartz. The material of the piezoelectric layer 130 may be of various cutting directions.

In some embodiments, the material of the piezoelectric layer 130 is $LiNbO_3$, and a cutting direction of the piezoelectric layer 130 is Z-cut.

The Z-cut piezoelectric material of $LiNbO_3$ can improve a bandwidth of the lamb wave resonator 100.

In some embodiments, the material of the piezoelectric layer 130 is $LiNbO_3$ with a Euler angle of (0, 20, 0) to (0, 40, 0).

For example, the material of the piezoelectric layer 130 is $LiNbO_3$ with a Euler angle of (0, 25, 0), (0, 30, 0), or (0, 35, 0).

Three numbers $(\alpha, \beta, \gamma)$ in the Euler angle indicate that a single crystal that is directly pulled first rotates around a z-axis by $\alpha$, then rotates around an x-axis by $\beta$, and finally rotates around the z-axis by y. In this way, a cutting direction of the crystal is determined. Therefore, when the Euler angle is determined, the cutting direction of the crystal is determined accordingly.

When the Euler angle of the material of the piezoelectric layer 130 is within the foregoing range, a resonance characteristic of the lamb wave resonator 100 can be improved.

For example, the piezoelectric layer 130 is formed by using a process such as magnetron sputtering, physical vapor deposition, chemical vapor deposition, epitaxial growth, intercrystalline bonding (bonding), or the like.

An acoustic impedance of the macromolecular material is close to an acoustic impedance of air, so that most acoustic wave energy can be well limited in the piezoelectric layer 130 by using the materials of the acoustic wave reflection layer 120 and the piezoelectric layer 130.

Finite element simulation is performed on the lamb wave resonator 100 provided in this embodiment of this application by using an example in which the material of the substrate 110 is Si, the material of the acoustic wave reflection layer 120 is PI, and the material of the piezoelectric layer 130 is Z-cut $LiNbO_3$.

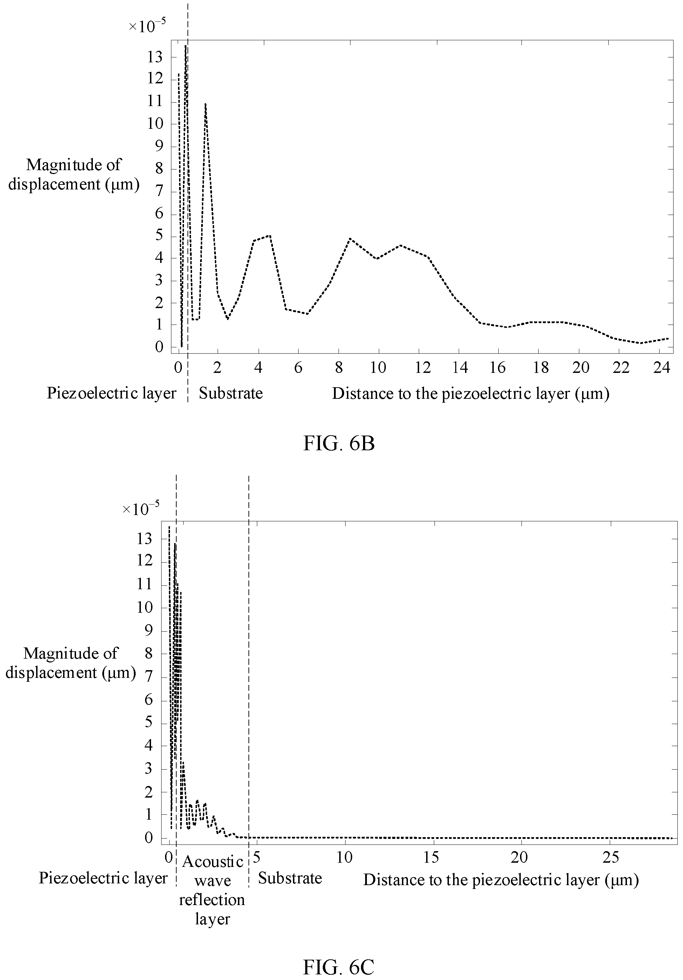

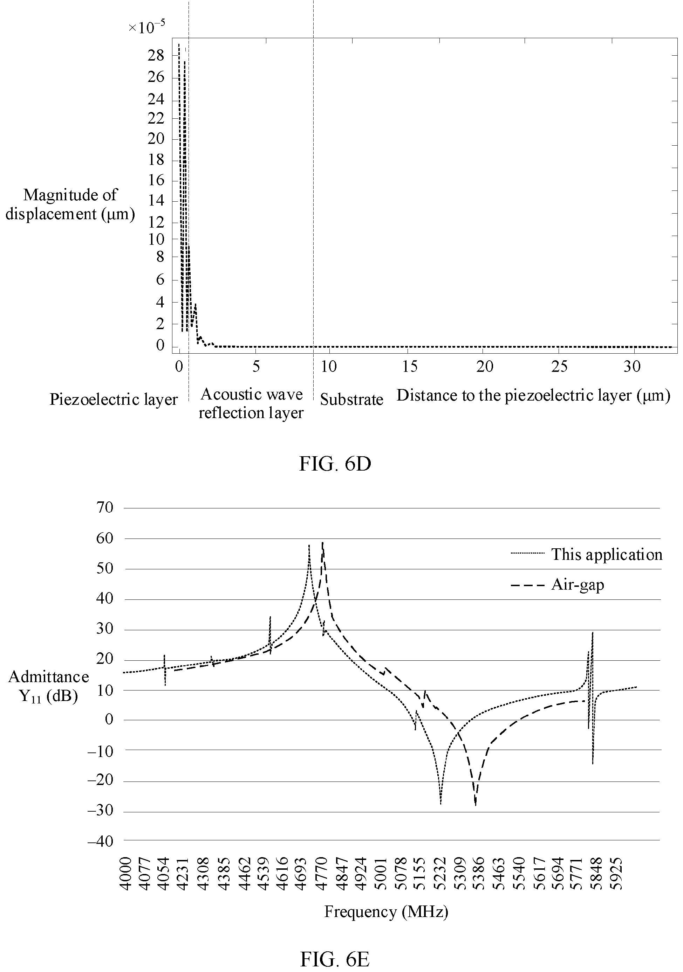

A model for the finite element simulation of the lamb wave resonator 100 is shown in FIG. 6A. A thickness of the acoustic wave reflection layer 120 (the material is PI) in the model is changed, to obtain performance of the lamb wave resonator 100 under different thicknesses of the acoustic wave reflection layer 120. In addition, a position (as shown in a dash-dotted line) in the middle of the model is selected, and a diagram of particle displacement at the position is made, to represent a propagation depth of the acoustic wave energy in a vertical direction. When there is no acoustic wave reflection layer 120 (the thickness of the acoustic wave reflection layer 120 is 0 $\mu$m), particle displacement distribution in the vertical direction is shown in FIG. 6B. When the thickness of the acoustic wave reflection layer 120 is 4 $\mu$m, particle displacement distribution in the vertical direction is shown in FIG. 6C. When the thickness of the acoustic wave reflection layer 120 is 8 $\mu$m, particle displacement distribution in the vertical direction is shown in FIG. 6D. Horizontal coordinates in FIG. 6B to FIG. 6D are positions of thicknesses from top to bottom of the model in FIG. 6A. Vertical coordinates in FIG. 6B to FIG. 6D are magnitudes of particle displacement.

When the thickness of the acoustic wave reflection layer 120 is 0 $\mu$m, the particle displacement at the substrate 110 is very strong, indicating that the acoustic wave energy leaks to the substrate 110. As the thickness of the acoustic wave reflection layer 120 increases, particle displacement in the substrate 110 and the acoustic wave reflection layer 120 decreases, and most acoustic wave energy is well limited in the piezoelectric layer 130. Performance of the lamb wave resonator 100 changes accordingly when the thickness of the acoustic wave reflection layer 120 is different. However, when the material of the acoustic wave reflection layer 120 is different, a requirement on the thickness of the acoustic wave reflection layer 120 is also different.

In some embodiments, a minimum thickness of the acoustic wave reflection layer 120 is y, and the minimum thickness y may be obtained through calculation by using the following formula:

$$y = 77.75379 * R^2 - 173.22328 * R + 97.70404$$

In this embodiment of this application, when the material of the acoustic wave reflection layer 120 is different, the acoustic wave reflection coefficient R of the acoustic wave reflection layer 120 is different, and the minimum thickness of the acoustic wave reflection layer 120 is also different.

In some embodiments, a thickness range of the acoustic wave reflection layer 120 is 3.5 $\mu$m to 30 $\mu$m.

For example, the thickness of the acoustic wave reflection layer 120 is 10 $\mu$m, 15 $\mu$m, 20 $\mu$m, or 25 $\mu$m.

Table 2 shows the minimum thickness y of the acoustic wave reflection layer 120 under different acoustic wave reflection coefficients R. A smaller acoustic wave reflection coefficient R of a material selected for the acoustic wave reflection layer 120 indicates a larger thickness of the acoustic wave reflection layer 120.

It may be learned from Table 2 that, when the material of the acoustic wave reflection layer 120 is different, the thickness of the acoustic wave reflection layer 120 is related to the performance of the lamb wave resonator 100. However, when the material of the acoustic wave reflection layer 120 is fixed, as shown in Table 3, the thickness of the acoustic wave reflection layer 120 is still related to the performance of the lamb wave resonator 100.

Table 2 Relationship between the minimum thickness of the acoustic wave reflection layer and the reflection coefficient of the acoustic wave reflection layer

| $Z_{120}$ | R | y ($\mu$m) |
|---|---|---|
| 1.2263 | 0.8638 | 6 |
| 2.4526 | 0.7450 | 12 |
| 4.9052 | 0.5476 | 26 |
| 7.3578 | 0.3903 | 42 |

Table 3 Performance parameters of the lamb wave resonator under different thicknesses of the acoustic wave reflection layer

| PI thickness ($\mu$m) | Resonance frequency fr (MHz) | Anti-resonance frequency fa (MHz) | Relative distance between resonant peak and anti-resonant peak (fa-fr)/fa | Electromechanical coupling coefficient K2 |
|---|---|---|---|---|
| 0 | 5121.5 | 5339 | 0.040737966 | 0.096553875 |
| 1 | 4788 | 5150.5 | 0.070381516 | 0.162097965 |
| 2 | 4900 | 5220 | 0.061302682 | 0.142426255 |
| 3 | 4793 | 5212 | 0.080391404 | 0.183387394 |
| 4 | 4755 | 5229 | 0.090648308 | 0.204776631 |
| 5 | 4914 | 5341 | 0.079947575 | 0.1824522 |
| 6 | 4783 | 5279 | 0.093957189 | 0.211586471 |
| 7 | 4727 | 5260 | 0.101330798 | 0.226605552 |
| 8 | 4724 | 5238.5 | 0.098215138 | 0.220285519 |
| 9 | 4703 | 5257 | 0.105383298 | 0.234769113 |

Finite element simulation is performed by using an example in which the material of the substrate is Si, and the material of the piezoelectric layer is Z-cut LiNbO$_3$. An air-gap lamb wave resonator has a resonance frequency fr of 4778 MHz, an anti-resonance frequency fa of 5379, a relative distance between a resonance peak and an anti-resonance peak (fa-fr)/fa of 0.111730805, and an electromechanical coupling coefficient K2 of 0.247427933. It is found through comparison that when the thickness of the acoustic wave reflection layer 120 is greater than 6 $\mu$m, performance of the lamb wave resonator 100 provided in this embodiment of this application is close to performance of the air-gap lamb wave resonator, and a relative bandwidth and the electromechanical coupling coefficient of the lamb wave resonator 100 are almost the same as those of the air-gap lamb wave resonator.

FIG. 6E shows a comparison diagram of an admittance curve of the lamb wave resonator 100 and an admittance curve of the air-gap lamb wave resonator when the thickness of the acoustic wave reflection layer 120 is 8 $\mu$m. In FIG. 6E, a horizontal coordinate is a frequency, and a vertical coordinate is an admittance. It may be learned from the figure that the performance of the lamb wave resonator 100 provided in this embodiment of this application is not greatly different from the performance of the air-gap lamb wave resonator. However, a preparation process of the lamb wave resonator 100 provided in this embodiment of this application is significantly simple and has high yield.

In some embodiments, a thickness of the piezoelectric layer 130 is 0.2 $\mu$m to 1 $\mu$m.

For example, the thickness of the piezoelectric layer 130 is 0.3 $\mu$m, 0.4 $\mu$m, 0.5 $\mu$m, 0.6 $\mu$m, 0.7 $\mu$m, 0.8 $\mu$m or 0.9 $\mu$m.

The thickness of the piezoelectric layer 130 is directly related to a frequency of the lamb wave resonator 100, and a thinner piezoelectric layer 130 indicates a higher frequency of the lamb wave resonator 100. In this application, the thickness of the piezoelectric layer 130 is limited to 0.2 $\mu$m to 1 $\mu$m, so that the lamb wave resonator 100 can be used in a high frequency, and the high frequency may be, for example, above 3.3 GHz.

The interdigital transducer 140 is disposed on a side that is of the piezoelectric layer 130 and that is away from the substrate 110. For example, the interdigital transducer 140 is disposed on a surface that is of the piezoelectric layer 130 and that is away from the substrate 110.

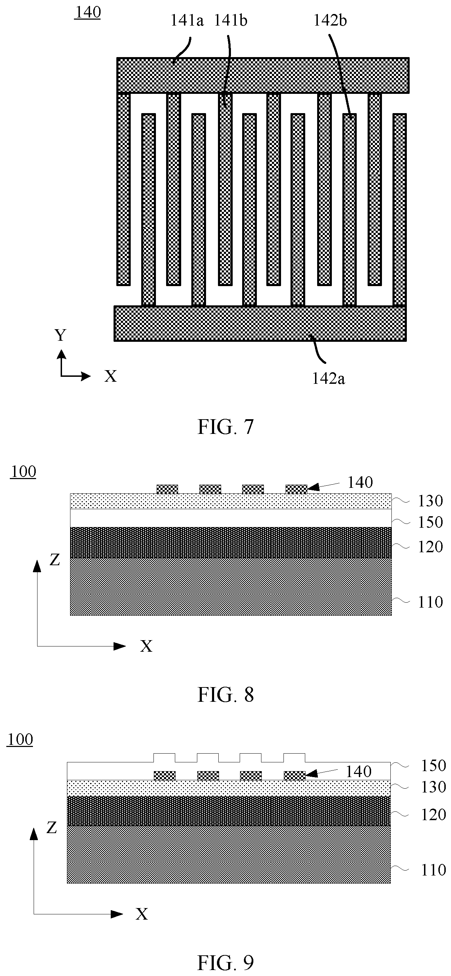

The interdigital transducer 140 may be understood as a metal pattern formed on the surface of the piezoelectric layer 130, and a shape of the metal pattern is like crossed fingers of two hands, with a function of implementing acoustic-electric energy conversion. In an embodiment, as shown in FIG. 7, the interdigital transducer 140 includes a first busbar (busbar) 141a and a second busbar 142a that are disposed opposite to each other, a plurality of first electrode fingers (interdigitated transducer, IDT) 141b, and a plurality of second electrode fingers 142b. An extension direction of each of the first busbar 141a and the second busbar 142a is parallel to a first direction X, and an extension direction of the first electrode finger 141b is parallel to a second direction Y. The first electrode finger 141b protrudes from the first busbar 141a to the second busbar 142a. The plurality of first electrode fingers 141b are sequentially arranged along the extension direction (the first direction X) of the first busbar 141a, and the plurality of first electrode fingers 141b are coupled to the first busbar 141a. An extension direction of the second electrode finger 142b is parallel to the second direction Y. The second electrode finger 142b protrudes from the second busbar 142a to the first busbar 141a. The plurality of second electrode fingers 142b are sequentially arranged along the extension direction (the first direction X) of the second busbar 142a, and the plurality of second electrode fingers 142b are coupled to the second busbar 142a. The first direction X intersects with the second direction Y. Parallelism in this embodiment of this application includes approximate parallelism, and deviations within a range of process errors (for example, $\pm 5°$) all belong to the parallelism in embodiments of this application.

The plurality of first electrode fingers 141b and the plurality of second electrode fingers 142b are sequentially alternately arranged between the first busbar 141a and the second busbar 142a in the first direction X, and the first electrode finger 141b and the second electrode finger 142b are not in contact.

The foregoing "the plurality of first electrode fingers 141b and the plurality of second electrode fingers 142b are sequentially alternately arranged between the first busbar 141a and the second busbar 142a in the first direction X" means that between the first busbar 141a and the second busbar 142a, one second electrode finger 142b is disposed between every two first electrode fingers 141b, and one first electrode finger 141b is disposed between every two second electrode fingers 142b.

A quantity of the first electrode fingers 141b and a quantity of the second electrode fingers 142b in the interdigital transducer 140 are not limited, and may be set according to a requirement. The plurality of first electrode fingers 141b may be arranged at an equal pitch, or may be arranged at a non-equal pitch. Similarly, the plurality of second electrode fingers 142b may be arranged at an equal pitch, or may be arranged at a non-equal pitch. The first electrode finger 141b is used as an example. That the plurality of first electrode fingers 141b are arranged at a non-equal pitch means that a pitch between at least one pair of adjacent first electrode fingers 141b is different from a pitch between another pair of adjacent first electrode fingers 141b.

In addition, that the plurality of first electrode fingers 141b and the plurality of second electrode fingers 142b are sequentially alternately arranged may indicate that pitches between the first electrode fingers 141b and the second electrode fingers 142b that are adjacent are the same; or may indicate that pitches between a plurality of pairs of first electrode fingers 141b and second electrode fingers 142b that are adjacent are not totally the same, that is, a pitch between at least one pair of first electrode finger 141b and second electrode finger 142b that are adjacent is different from a pitch between another pair of first electrode finger 141b and second electrode finger 142b that are adjacent.

In some embodiments, a pitch between a first electrode finger 141b and a second electrode finger 142b that are

adjacent is 2 μm to 10 μm.

For example, the pitch between the first electrode finger 141b and the second electrode finger 142b that are adjacent is 3 μm to 4 μm, 4 μm to 5 μm, 5 μm to 6 μm, 6 μm to 7 μm, 7 μm to 8 μm, 8 μm to 9 μm, or 9 μm to 10 μm.

The pitch between the first electrode finger 141b and the second electrode finger 142b directly affects the frequency of the lamb wave resonator 100, and further affects the bandwidth of the lamb wave resonator 100. Generally, a larger pitch indicates a larger bandwidth. Therefore, the pitch between the first electrode finger 141b and the second electrode finger 142b that are adjacent is limited to 2 μm to 10 μm, so that the lamb wave resonator 100 can operate in a frequency band of a fifth generation mobile communication technology (5th generation mobile communication technology, 5G) and have a wide bandwidth.

In some embodiments, a width of the first electrode finger 141b is 200 nm to 1000 nm, and a width of the second electrode finger 142b is 200 nm to 1000 nm.

For example, the width of each of the first electrode finger 141b and the second electrode finger 142b is between 200 nm and 300 nm, between 300 nm and 400 nm, between 400 nm and 500 nm, between 500 nm and 600 nm, between 600 nm and 700 nm, between 700 nm and 800 nm, between 800 nm and 900 nm, or between 900 nm and 1000 nm.

A duty cycle mainly affects the bandwidth of the lamb wave resonator 100, and further affects the frequency of the lamb wave resonator 100. The duty cycle = a width of an electrode finger/(the width of the electrode finger + a pitch between electrode fingers). When the pitch between the electrode fingers is determined, the bandwidth and the frequency of the lamb wave resonator 100 may be adjusted by adjusting the width of the electrode finger. Therefore, the width of each of the first electrode finger 141b and the second electrode finger 142b that are adjacent is limited to 200 nm to 1000 nm, so that the lamb wave resonator 100 can operate in a 5G frequency band and have a wide bandwidth.

It may be understood that, the pitch (pitch) between the first electrode finger 141b and the second electrode finger 142b, and finger widths of the first electrode finger 141b and the second electrode finger 142b are mainly affected by photoetching and development processes. The resonance frequency and the bandwidth of the lamb wave resonator 100 may be changed by adjusting the pitch between the first electrode finger 141b and the second electrode finger 142b, and the finger widths of the first electrode finger 141b and the second electrode finger 142b. Therefore, an electronic signal of a specific frequency may pass through the lamb wave resonator 100, and an electronic signal of another frequency may be filtered out by the lamb wave resonator 100.

It should be noted that, the first busbar 141a, the first electrode finger 141b, the second busbar 142a, and the second electrode finger 142b may be prepared at the same time. Alternatively, the first busbar 141a and the first electrode finger 141b may be prepared first, and then the second busbar 142a and the second electrode finger 142b are prepared. Alternatively, the second busbar 142a and the second electrode finger 142b are first prepared, and then the first busbar 141a and the first electrode finger 141b are prepared.

The material of each of the first electrode finger 141b and the second electrode finger 142b may include one or more of aluminum (Al), copper (Cu), platinum (Pt), gold (Au), nickel (Ni), titanium (Ti), Ag (silver), chromium (Cr), molybdenum (Mo), tungsten (W), tantalum (Ta), and the like.

In some embodiments, the substrate 110 in the lamb wave resonator 100 provided in this application is a silicon substrate. The material of the acoustic wave reflection layer 120 is PI, and the thickness of the acoustic wave reflection layer 120 is 8 μm. The material of the piezoelectric layer 130 is Z-cut $LiNbO_3$, and the thickness of the piezoelectric layer 130 is 400 nm. The material of each of the first electrode finger 141b and the second electrode finger 142b is Al. The thickness of each of the first electrode finger 141b and the second electrode finger 142b is 100 nm. The width of each of the first electrode finger 141b and the second electrode finger 142b is 500 nm. The pitch between the first electrode finger 141b and the second electrode finger 142b that are adjacent is 3 μm.

According to the lamb wave resonator 100 provided in this embodiment of this application, the acoustic wave reflection layer 120 is disposed on a side that is of the piezoelectric layer 130 and that is close to the substrate 110, and the acoustic impedance of the acoustic wave reflection layer 120 is less than acoustic impedance of the piezoelectric layer 130. In this way, the acoustic wave is reflected on the surface that is of the acoustic wave reflection layer 120 and that faces the piezoelectric layer 130, and is reflected back to the piezoelectric layer 130, so as to limit the acoustic wave energy in the piezoelectric layer 130. The acoustic wave reflection layer 120 may be implemented by using a simple process, thereby simplifying a preparation process of the lamb wave resonator 100 and reducing a preparation difficulty of the lamb wave resonator 100. In addition, in the lamb wave resonator 100 provided in this application, no air cavity may need to be formed in the substrate 110. When no air cavity is disposed in the substrate 110, mechanical strength of the lamb wave resonator 100 can be enhanced, and yield of the lamb wave resonator 100 can be improved.

In addition, the lamb wave resonator 100 provided in this embodiment of this application is applicable to a first-order anti-symmetric (A1) mode, a lowest-order symmetric (S0) mode, and a lowest-order (SH0) mode, and has a wide application scope. In addition, a requirement of devices for a high-frequency and large-bandwidth resonator can be met. For example, when a filter of a frequency band (sub-6G frequency band) below 6G whose operating frequency ranges from 450 MHz to 6000 MHz in a 5G frequency band such as an n77 frequency band (for example, 3.3 GHz to 4.2 GHz), an n78 frequency band (for example, 3.3 GHz to 3.8 GHz), or an n79 frequency band (for example, 4.4 GHz to 5.0 GHz) is required, the lamb wave resonator 100 provided in this embodiment of this application may be used.

In some embodiments, the lamb wave resonator 100 further includes a frequency shift layer, where the frequency shift layer is configured to adjust a frequency of the lamb wave resonator 100.

In an embodiment, as shown in FIG. 8, a frequency shift layer 150 is disposed between the piezoelectric layer 130 and the acoustic wave reflection layer 120.

In another embodiment, as shown in FIG. 9, the frequency shift layer 150 is disposed on a side that is of the interdigital transducer 140 and that is away from the piezoelectric layer 130.

Certainly, the frequency shift layer 150 may alternatively be disposed both below the piezoelectric layer 130 and above the interdigital transducer 140.

A material of the frequency shift layer 150 may be, for example, silicon nitride (SiN), aluminum oxide ($Al_2O_3$), or silicon oxide ($SiO_2$).

In this application, when the lamb wave resonator 100 includes the frequency shift layer 150, a structure of another membrane layer in the lamb wave resonator 100 does not need to be changed, and the frequency of the lamb wave resonator 100 may be adjusted to a required value by adjusting a thickness of the frequency shift layer 150.

In some embodiments, the lamb wave resonator 100 further includes a temperature compensation layer, where the temperature compensation layer is configured to compensate for a temperature coefficient of frequency of the lamb wave resonator 100.

A position at which the temperature compensation layer is disposed is the same as a position at which the frequency shift layer 150 is disposed. For example, the temperature compensation layer is disposed between the piezoelectric layer 130 and the acoustic wave reflection layer 120. Alternatively, the temperature compensation layer is disposed on a side that is of the interdigital transducer 140 and that is away from the piezoelectric layer 130. Alternatively, for example, the temperature compensation layer is disposed both below the piezoelectric layer 130 and above the interdigital transducer 140.

A material of the temperature compensation layer may be, for example, $SiO_2$.

Certainly, the lamb wave resonator 100 may alternatively include both the frequency shift layer 150 and the temperature compensation layer, and the frequency shift layer 150 and the temperature compensation layer are disposed in a stacked manner, or the frequency shift layer 150 and the temperature compensation layer are disposed on two opposite sides of the piezoelectric layer 130.

In this application, when the lamb wave resonator 100 includes the temperature compensation layer, temperature compensation may be performed on the lamb wave resonator 100 by using the temperature compensation layer, so that an absolute value of the temperature coefficient of frequency (TCF) of the lamb wave resonator 100 decreases.

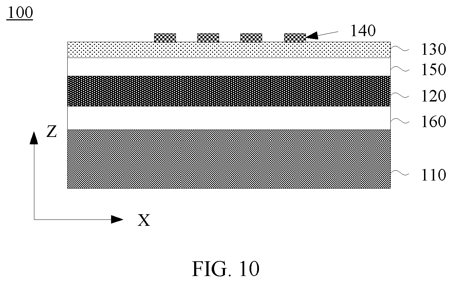

In some embodiments, as shown in FIG. 10, the lamb wave resonator 100 further includes a phononic crystal layer 160, where the phononic crystal layer 160 is disposed between the substrate 110 and the acoustic wave reflection layer 120.

The phononic crystal layer 160 includes a phononic crystal (phononic crystal), and the phononic crystal is, for example, of a columnar structure.

The phononic crystal layer 160 is disposed in the lamb wave resonator 100, so that the phononic crystal layer 160 may further limit an acoustic wave, supplement an acoustic wave reflection function to the acoustic wave reflection layer 120, and improve the bandwidth of the lamb wave resonator 100.

Certainly, the lamb wave resonator 100 may include both the frequency shift layer 150 and the phononic crystal layer 160, or the lamb wave resonator 100 may include both the temperature compensation layer and the phononic crystal layer 160, or the lamb wave resonator 100 may include both the frequency shift layer 150, the temperature compensation layer, and the phononic crystal layer 160. The structure in FIG. 10 is merely an example, and is not limited.

An embodiment of this application further provides a preparation method for a lamb wave resonator 100, and the method is used to prepare any one of the foregoing lamb wave resonator 100.

For example, when preparing the lamb wave resonator 100, an acoustic wave reflection layer 120 is first directly formed on a substrate 110, and the substrate 110 does not need to be hollowed out. Then, a piezoelectric layer 130 and an interdigital transducer 140 are formed.

A surface of the substrate 110 is a plane, and there is no recessed section after being hollowed out. It may be understood that the plane herein is relative, and the surface with a height difference within a process error range belongs to the plane in this embodiment of this application.

Alternatively, for example, when preparing the lamb wave resonator 100, the method further includes a step of hollowing out the substrate 110. In this case, a formed substrate 110 may be shown in FIG. 4A and FIG. 4B.

The foregoing descriptions are merely specific implementations of this application, but are not intended to limit the protection scope of this application. Any variation or replacement within the technical scope disclosed in this application shall fall within the protection scope of this application. Therefore, the protection scope of this application shall be subject to the protection scope of the claims.

**Claims**

1. A lamb (lamb) wave resonator, comprising:

   a substrate;
   an acoustic wave reflection layer, disposed on a side of the substrate;
   a piezoelectric layer, disposed on a side that is of the acoustic wave reflection layer and that is away from the substrate, wherein an acoustic wave reflection coefficient of a surface that is of the acoustic wave reflection layer and that faces the piezoelectric layer is R, and $0.5 \leq R \leq 0.86$; and
   an interdigital transducer, disposed on a side that is of the piezoelectric layer and that is away from the substrate.

2. The lamb wave resonator according to claim 1, wherein $0.55 \leq R \leq 0.8$.

3. The lamb wave resonator according to claim 1 or 2, wherein a minimum thickness of the acoustic wave reflection layer is y, and $y = 77.75379 * R^2 - 173.22328 * R + 97.70404$.

4. The lamb wave resonator according to claim 1 or 2, wherein a thickness of the acoustic wave reflection layer is from 3.5 $\mu$m to 30 $\mu$m.

5. The lamb wave resonator according to any one of claims 1 to 4, wherein a material of the acoustic wave reflection layer is a macromolecular material.

6. The lamb wave resonator according to claim 5, wherein the material of the acoustic wave reflection layer comprises polyimide, polydimethylsiloxane, polymethyl methacrylate, polyvinylidene fluoride, or polyethylene glycol terephthalate.

7. The lamb wave resonator according to any one of claims 1 to 6, wherein the acoustic wave reflection layer is of a single membrane layer structure.

8. The lamb wave resonator according to any one of claims 1 to 7, wherein a cutting direction of a material of the piezoelectric layer is Z-cut.

9. The lamb wave resonator according to any one of claims 1 to 8, wherein a Euler angle of the material of the piezoelectric layer is (0, 20, 0) to (0, 40, 0).

10. The lamb wave resonator according to any one of claims 1 to 9, wherein the lamb wave resonator further comprises a frequency shift layer, and the frequency shift layer is configured to adjust a frequency of the lamb wave resonator; and the frequency shift layer is disposed between the piezoelectric layer and the acoustic wave reflection layer; and/or the frequency shift layer is disposed on a side that is of the interdigital transducer and that is away from the piezoelectric layer.

11. The lamb wave resonator according to any one of claims 1 to 10, wherein the lamb wave resonator further comprises a temperature compensation layer, and the temperature compensation layer is configured to compensate for a temperature coefficient of frequency of the lamb wave resonator; and the temperature compensation layer is disposed between the piezoelectric layer and the acoustic wave reflection layer; and/or the temperature compensation layer is disposed on the side that is of the interdigital transducer and that is away from the piezoelectric layer.

12. The lamb wave resonator according to any one of claims 1 to 11, wherein a thickness of the piezoelectric layer is 0.2 $\mu$m to 1 $\mu$m.

13. The lamb wave resonator according to any one of claims 1 to 12, wherein the interdigital transducer comprises a plurality of first electrode fingers and a plurality of second electrode fingers, and the plurality of first electrode fingers and the plurality of second electrode fingers are sequentially alternately arranged; and a width of each of the first electrode finger and the second electrode finger is 200 nm to 1000 nm, and/or a pitch between the first electrode finger and the second electrode finger that are adjacent is 2 $\mu$m to 10 $\mu$m.

14. The lamb wave resonator according to any one of claims 1 to 13, wherein a phononic crystal layer is further disposed between the substrate and the acoustic wave reflection layer.

15. The lamb wave resonator according to any one of claims 1 to 14, wherein a surface that is of the substrate and that faces the acoustic wave reflection layer is a plane.

16. The lamb wave resonator according to any one of claims 1 to 15, wherein no opening is disposed in the substrate.

17. A filter, comprising a plurality of cascaded lamb wave resonators, wherein the lamb wave resonator is the lamb wave resonator according to any one of claims 1 to 16.

18. A radio frequency module, comprising a filter and a power amplifier, wherein the filter is coupled to the power amplifier, and the filter is the filter according to claim 17.

19. An electronic device, comprising a filter and a circuit board, wherein the filter is disposed on the circuit board, and the filter is the filter according to claim 17.

20. A preparation method for a lamb wave resonator, wherein the method is used to prepare the lamb wave resonator according to any one of claims 1 to 16.

FIG. 1

FIG. 2

FIG. 3

FIG. 4A

FIG. 4B

FIG. 4C

100

140

130

Z

120

110

X

FIG. 5

140

130

120

110

FIG. 6A

FIG. 6B

FIG. 6C

FIG. 6D

FIG. 6E

FIG. 7

FIG. 8

FIG. 9

100

140

130

150

120

160

110

Z

X

FIG. 10

## INTERNATIONAL SEARCH REPORT

| International application No. |
|---|
| **PCT/CN2023/112621** |

### A. CLASSIFICATION OF SUBJECT MATTER

H03H9/17(2006.01)i

According to International Patent Classification (IPC) or to both national classification and IPC

### B. FIELDS SEARCHED

Minimum documentation searched (classification system followed by classification symbols)

IPC: H03H

Documentation searched other than minimum documentation to the extent that such documents are included in the fields searched

Electronic data base consulted during the international search (name of data base and, where practicable, search terms used)

VEN, CNABS, CNTXT, WOTXT, EPTXT, USTXT, CNKI, IEEE: 兰姆波, 谐振器, 反射层, 叉指电极, 反射系数, 压电层, lamb, resonator, reflective w layer, interdigital w electrodes, reflection w coefficient, piezoelectric w layer

### C. DOCUMENTS CONSIDERED TO BE RELEVANT

| Category* | Citation of document, with indication, where appropriate, of the relevant passages | Relevant to claim No. |
|---|---|---|
| Y | CN 110572135 A (SHANGHAI INSTITUTE OF MICROSYSTEM AND INFORMATION TECHNOLOGY, CHINESE ACADEMY OF SCIENCES) 13 December 2019 (2019-12-13) description, paragraphs 3-80, and figures 1-6 | 1-20 |
| Y | US 2019181830 A1 (II-VI INC. et al.) 13 June 2019 (2019-06-13) description, paragraphs 19-93 | 1-20 |
| Y | CN 113328723 A (SHANGHAI INSTITUTE OF MICROSYSTEM AND INFORMATION TECHNOLOGY, CHINESE ACADEMY OF SCIENCES) 31 August 2021 (2021-08-31) description, paragraphs 5-113, and figure 1 | 1-20 |
| A | CN 103269209 A (SHANDONG UNIVERSITY OF SCIENCE AND TECHNOLOGY) 28 August 2013 (2013-08-28) entire document | 1-20 |

☐ Further documents are listed in the continuation of Box C.　　☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **30 October 2023** | **02 November 2023** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2023/112621**

| Patent document cited in search report | | | Publication date (day/month/year) | Patent family member(s) | | | Publication date (day/month/year) |
|---|---|---|---|---|---|---|---|
| CN | 110572135 | A | 13 December 2019 | CN | 110572135 | B | 14 December 2021 |
| US | 2019181830 | A1 | 13 June 2019 | US | 2022085790 | A1 | 17 March 2022 |
| | | | | US | 11218132 | B2 | 04 January 2022 |
| | | | | CN | 109921759 | A | 21 June 2019 |
| CN | 113328723 | A | 31 August 2021 | None | | | |
| CN | 103269209 | A | 28 August 2013 | CN | 103269209 | B | 03 August 2016 |

Form PCT/ISA/210 (patent family annex) (July 2022)

**EP 4 564 667 A1**

**Patent documents cited in the description**

- CN 202211036176